# EUROPÄISCHE PATENTANMELDUNG

(11) **EP 1 460 661 A1**
(43) Veröffentlichungstag der Anmeldung: **22.09.2004**
(21) Anmeldenummer: 04001515.8
(22) Anmeldetag: 24.01.2004
(51) Int. Cl.: H01H 9/54, H05B 3/74, F24C 7/08

(54) **Schaltanordnung für ein Elektrogerät**

(30) Priorität: 15.03.2003 DE 10311447
(71) Anmelder: Schott Glas, 55122 Mainz (DE); CARL-ZEISS-STIFTUNG trading as SCHOTT GLAS, 55122 Mainz (DE)
(72) Erfinder: Engelmann, Harry, 55218 Ingelheim (DE); Schaupert, Kurt, Dr., 65719 Hofheim (DE)
(74) Vertreter: Fleck, Hermann-Josef, Dr.-Ing.

(57) **Zusammenfassung**

Die Erfindung betrifft eine Schaltungsanordnung für ein Elektrogerät mit einer Steuereinrichtung (10) und einem mit einem Spannungsversorgungsanschluss (L, N) verbunden Netzteil (12) zur Versorgung von zu steuernden Funktionseinheiten des Elektrogeräts. Am Stromversorgungsanschluss (L, N) ist ein Schalter (14) zur primärseitigen Trennung des Netzteils (12) vom Stromversorgungsanschluss (L, N) vorgesehen. Der Schalter (14) weist einen Piezo-Schalter auf, welcher im nicht aktivierten Zustand geöffnet ist.

## Beschreibung

Die Erfindung betrifft eine Schaltungsanordnung für ein Elektrogerät mit einer Steuereinrichtung und einem mit einem Stromversorgungsanschluss verbundenen Netzteil zur Versorgung von zu steuernden Funktionseinheiten des Elektrogeräts. Am Stromversorgungsanschluss ist ein Schalter zur primärseitigen Trennung des Netzteils vom Stromversorgungsanschluss vorgesehen.

Aus dem Stand der Technik ist bekannt, Elektrogeräte beispielsweise im Haushalt mit elektronischen Steuerungen auszurüsten. Insbesondere werden elektronische Berührschalter ("Touch Controls") für Kochfelder, Backöfen, Geschirrspüler, Waschmaschinen und dergleichen Hausgeräte eingesetzt. Nachteilig ist hierbei, dass die Tasten in Bereitschaft gehalten werden müssen, um auf Eingaben reagieren zu können. Hierbei verbrauchen die Geräte einen sogenannten Ruhestrom. Dieser Ruhestrom wird durch den Verbrauch der implementierten elektronischen Schaltungen und den Verlusten des Netztransformators bestimmt. Die Leistungsaufnahme liegt hierbei typischer Weise im Bereich von 1 W. Eine derartige Leistungsaufnahme ist zwar relativ gering, kann sich jedoch bei der heute üblichen großen Anzahl von im Einsatz befindlichen Geräten insgesamt in einem erheblichen Ruhestromverbrauch niederschlagen.

Aus dem Stand der Technik ist weiterhin bekannt, elektronische Steuerungen auch ohne Ruhestromverbrauch zu realisieren. Dabei kann beispielsweise ein zentraler mechanischer Schalter vorgesehen sein. Nachteilig ist hierbei jedoch, dass damit das Bedienkonzept von berührungslosen Schaltern durchbrochen wird. Der mechanische Schalter benötigt zur Änderung des Zustandes zwischen EIN und AUS einen Weg des Schaltknebels. Die Bedienoberfläche muss daher eine Öffnung aufweisen, wodurch die Herstellungskosten einer derartigen Bedienoberfläche vergrößert werden, die Reinigung erschwert ist und zudem designerische Einschränkungen in Kauf genommen werden müssen.

Aus der DE 199 23 148 A1 ist ein Kochfeld bekannt, bei welchem die Energieversorgung über einen Reed-Kontakt eingeschaltet werden kann. Nachteilig bei der Verwendung eines derartigen Reed-Kontaktes ist jedoch, dass zur Aktivierung ein Magnet erforderlich ist, welcher unter Umständen abhanden kommen kann.

Aus der DE 199 44 235 A1 ist bekannt, die Energieversorgung eines bereits in der DE 199 23 148 A1 beschriebenen Kochfeldes über einen Reed-Kontakt abzuschalten. Der Magnet ist somit nur dazu notwendig, das Elektrogerät in einen Ruhezustand ohne Ruhestromverbrauch zu bringen. Falls der Magnet abhanden kommt, verbraucht das Elektrogerät im Ruhezustand nach wie vor Energie.

Alternativ beschreibt die DE 199 32 453 C2 eine Möglichkeit, ein Hausgerät im Ruhezustand ohne Ruhestromverbrauch bereitzustellen. Hierbei wird das Netzteil des Hausgerätes mittels eines Thyristors eingeschaltet, der durch einen Optokoppler über ein geräteexternes Datennetz eingeschaltet wird. Es ist somit möglich, das Hausgerät lokal derart abzuschalten, dass kein Ruhestrom verbraucht wird, und über eine zentrale Steuerung wieder einzuschalten. Der Energieverbrauch über Nacht oder in der Urlaubszeit entfällt somit. Nachteilig ist jedoch der Verbrauch in der noch verbleibenden Bereitschaftszeit, denn der Energieverbrauch der zentralen Steuerung fällt ganztägig zusätzlich an.

Es ist daher Aufgabe der Erfindung, eine Schaltungsanordnung für ein Elektrogerät anzugeben, welche es gestattet, das Elektrogerät auf einfacher Weise aus einem Ruhezustand ohne Ruhestromverbrauch in Betrieb zu nehmen und beim Ausschalten in einen Ruhezustand ohne Ruhestromverbrauch zu bringen. Darüber hinaus soll es die erfindungsgemäße Schaltungsanordnung ermöglichen, den Einsatz von mechanischen Schaltern, welche eine Öffnung in der Bedienoberfläche benötigen, zu vermeiden und somit die Herstellungskosten für die Bedienoberfläche zu minimieren und eine komfortable Reinigung derselben zu ermöglichen.

Diese Aufgabe der Erfindung wird durch die Merkmale des Anspruches 1 gelöst. Vorteilhafte Weiterbildungen sind in den Unteransprüchen beschrieben.

Demgemäss weist der Schalter zur primärseitigen Trennung des Netzteils vom Stromversorgungsanschluss einen Piezo-Schalter auf, welcher im nicht aktivierten Zustand geöffnet ist.

Ein derartiger Piezo-Schalter kann unter geschlossenen Metall- und Glasflächen oder dergleichen Flächen angebracht und durch diese hindurch aktiviert werden. Um einen Piezo-Schalter zu aktivieren, reicht eine geringe Betätigungsweite aus, welche durch derartige Flächen, wie sie im allgemeinen bei Bedienblenden zum Einsatz kommen, gewährleistet ist.

Gemäss einer bevorzugen Ausführungsform ist der Piezo-Schalter mit einer Leistungshalbleiterschaltung verbunden, welche bei Betätigung des Piezoschalters die Steuereinrichtung zu deren Aktivierung mit dem Stromversorgungsanschluss verbindet. Damit wird erreicht, dass die Steuereinrichtung den zur Aktivierung weiterer Funktionen notwendigen Strom zumindest kurzzeitig zur Verfügung gestellt bekommt.

Bei Betätigung des Piezoschalters kann an diesem aufgrund der aufgewendeten Bedienkraft durch den Bediener kurzzeitig eine Spannung zum Aktivieren der Leistungshalbleiterschaltung erzeugt werden. Diese Spannung kann dazu verwendet werden, dass die somit aktivierte Leistungshalbleiterschaltung die Steuereinrichtung über das Netzteil mit dem Stromversorgungsanschluss verbindet.

Gemäß einer bevorzugten Ausführungsform weist die Leistungshalbleiterschaltung zumindest einen TRIAC (Triode Alternating Current Switch) auf. Die vom Piezo-Schalter kurzfristig erzeugte Spannung reicht aus, einen derartigen TRIAC zu aktivieren.

Um die Stromversorgung für das Elektrogerät während des Betriebs aufrecht zu erhalten, kann die Steuereinrichtung in vorteilhafter Weise mit einer Selbsthalte-Schaltung verbunden sein, welche durch die Steuereinrichtung aktiviert werden kann. Somit bleibt die Stromversorgung erhalten.

Gemäß einer bevorzugten Ausführungsform weist die Selbsthalte-Schaltung zumindest einen Thyristor auf. Alternativ kann die Selbsthalte-Schaltung auch zumindest ein elektromechanisches Relais oder ein Reed-Relais aufweisen.

Um die Steuereinrichtung beim Abschalten des Elektrogerätes vom Stromversorgungsanschluss zu trennen, ist die Steuereinrichtung mit einer entsprechenden Halbleiterschaltung verbunden. Dabei kann die Steuereinrichtung zum Abtrennen vom Stromversorgungsanschluss und zum Abschalten des Elektrogerätes die Selbsthalte-Schaltung deaktivieren.

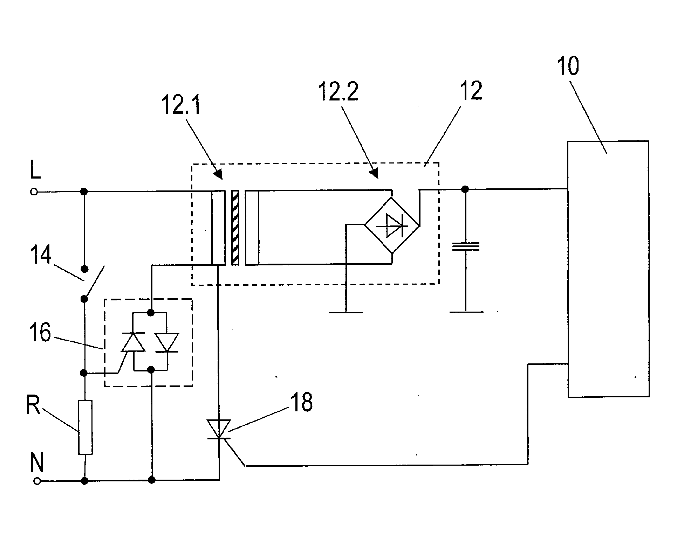

Nachfolgend wird die Erfindung anhand einer bevorzugten Ausführungsform unter Bezugnahme auf die beigefügte Zeichnung näher erläutert.

Die Figur zeigt in einem schematischen Schaltbild eine Schaltungsanordnung für ein Elektrogerät, wie sie beispielsweise in einem Haushaltsgerät zum Einsatz kommt.

Die Schaltungsanordnung weist einen Stromversorgungsanschluss mit zwei Einzelanschlüssen L und N auf. Schaltungsseitig ist zwischen den Stromversorgungsanschlüssen L und N eine Reihenschaltung bestehend aus einem Piezo-Schalter 14 und einem Widerstand R vorgesehen.

Der Spannungsversorgungsanschluss L ist mit einem primärseitigen Anschluss eines Transformators 12.1 verbunden. Der zweite primärseitige Anschluss des Transformators 12.1 ist zum einen über einen TRIAC 16 mit dem Stromversorgungsanschluss N und zum anderen über einen Thyristor 18 mit dem Stromversorgungsanschluss N verschaltet. Ein Steueranschluss des TRIAC 16 ist zwischen dem Piezo-Schalter 14 und dem Widerstand R verschaltet. Der Steueranschluss des Thyristors 18 ist mit einer Steuereinrichtung 10 verbunden. Die beiden sekundärseitigen Anschlüsse des Transformators 12.1 sind mit einer Gleichrichterbrücke 12.2 verschaltet, welche ausgangsseitig mit der Steuereinrichtung 10 verbunden ist. Der Transformator 12.1 und die Gleichrichterbrücke 12.2 bilden zusammen das Netzteil 12.

Die elektronische Steuereinrichtung 10 wird über den Piezo-Schalter 14 aktiviert. Der Piezo-Schalter 14 entnimmt Energie aus der durch den Bediener aufgewendeten Bedienkraft und steuert damit den TRIAC 16 an, welcher wiederum das Netzteil 12 einschaltet.

Als Piezo-Schalter 14 kann eine Anordnung aus einer Piezo-Keramik verwendet werden, welche zwei MOSFET-Transistoren derart ansteuert, dass der Widerstand des Schalters bei Betätigung von etwa 5 MOhm auf 10 Ohm absinkt. Die Bedienkraft beträgt hierbei etwa 1 N durch eine 0,6 mm starke Aluminiumschicht hindurch. Üblicherweise werden jedoch stärkere Bedienblenden benutzt, so dass die Bedienkraft hierbei zwischen etwa 3 bis 5 N liegt.

Zum Einschalten des Elektrogerätes wird der Piezo-Schalter 14 betätigt. Dieser schaltet den TRIAC 16 ein, der über das Netzteil 12 die Steuereinrichtung 10 kurzfristig mit Strom versorgt. Aufgrund.dieser kurzfristigen Stromversorgung schaltet die Steuereinrichtung 10 den Thyristor 18 ein, so dass die Stromversorgung erhalten bleibt. Somit ist der Thyristor 15 Teil einer Selbsthalte-Schaltung.

Wenn das Elektrogerät ausgeschaltet werden soll, löscht die Steuereinrichtung 10 das am Thyristor 18 anliegende Signal, wodurch die Stromversorgung praktisch komplett abgeschaltet wird. Alternativ kann anstatt des Thyristors 18 auch ein elektromechanisches Relais oder ein Reed-Relais verwendet werden.

In einer alternativen Ausführungsform kann der Piezo-Schalter 18 auch zur Spannungserzeugung genutzt werden und die zum Einschalten des TRIAC 16 erforderliche Energie bereitstellen. Derartige Piezo-Schalter sind an sich bekannt und werden zur kurzzeitigen Spannungsversorgung von drahtlos übertragenden Schaltern (beispielsweise von der Firma ENOcean angeboten) benutzt.

Mit der erfindungsgemäßen Schaltungsanordnung ist es möglich, ohne Verwendung eines mechanischen Schalters ein Elektrogerät in einen Ruhezustand zu bringen, in welchem kein Ruhestrom fließt.

## Patentansprüche

1. Schaltungsanordnung für ein Elektrogerät mit einer Steuereinrichtung (10) und einem mit einem Stromversorgungsanschluss (L, N) verbunden Netzteil (12) zur Versorgung von zu steuernden Funktionseinheiten des Elektrogeräts, wobei am Stromversorgungsanschluss (L, N) ein Schalter (14) zur primärseitigen Trennung des Netzteils (12) vom Stromversorgungsanschluss (L, N) vorgesehen ist,
**dadurch gekennzeichnet, dass**
der Schalter (14) einen Piezo-Schalter aufweist, welcher im nicht aktivierten Zustand geöffnet ist.

2. Schaltungsanordnung nach Anspruch 1,
**dadurch gekennzeichnet, dass**
der Piezo-Schalter (14) mit einer Leistungshalbleiterschaltung (16) verbunden ist, welche bei Betätigung des Piezo-Schalters die Steuereinrichtung (10) zu deren Aktivierung mit dem Stromversorgungsanschluss (L, N) verbindet.

3. Schaltungsanordnung nach Anspruch 2,
**dadurch gekennzeichnet, dass**
bei Betätigung des Piezo-Schalters (14) an diesem aufgrund der aufgewendeten Bedienkraft kurzzeitig eine Spannung zum Aktivieren der Leistungshalbleiterschaltung (16) erzeugt wird.

4. Schaltungsanordnung nach Anspruch 2 oder 3,
**dadurch gekennzeichnet, dass**
die Leistungshalbleiterschaltung (16) zumindest einen TRIAC (Triode Alternating Current Switch) aufweist.

5. Schaltungsanordnung nach einem der Ansprüche 3 bis 4,
**dadurch gekennzeichnet, dass**
die aktivierte Leistungshalbleiterschaltung (16) die Steuereinrichtung (10) über das Netzteil (12) mit dem Stromversorgungsanschluss (L, N) verbindet.

6. Schaltungsanordnung nach einem der Ansprüche 1 bis 5,
**dadurch gekennzeichnet, dass**
die Steuereinrichtung (10) zur Aufrechterhaltung der Stromversorgung für das Elektrogerät während des Betriebs mit einer Selbsthalte-Schaltung (18) verbunden ist, welche durch die Steuereinrichtung (10) aktivierbar ist.

7. Schaltungsanordnung nach Anspruch 4,
**dadurch gekennzeichnet, dass**
die Selbsthalte-Schaltung zumindest einen Thyristor (18) aufweist.

8. Schaltungsanordnung nach Anspruch 4 oder 5,
**dadurch gekennzeichnet, dass**
die Selbsthalte-Schaltung zumindest ein elektromechanisches Relais oder ein Reed-Relais aufweist.

9. Schaltungsanordnung nach einem der Ansprüche 1 bis 8,
**dadurch gekennzeichnet, dass**
die Steuereinrichtung (10) mit einer Halbleiterschaltung zum Abtrennen vom Stromversorgungsanschluss (L, N) verbunden ist.

10. Schaltungsanordnung nach einem der Ansprüche 2 bis 9,
**dadurch gekennzeichnet, dass**
die Steuereinrichtung (10) zum Abtrennen vom Stromversorgungsanschluss (L, N) und zum Abschalten des Elektrogeräts die Selbsthalte-Schaltung (18) deaktiviert.
